(19) Europäisches Patentamt
European Patent Office
Office européen des brevets

(11) **EP 3 668 290 B1**

(12) **EUROPEAN PATENT SPECIFICATION**

(45) Date of publication and mention
of the grant of the patent:
**27.10.2021 Bulletin 2021/43**

(51) Int Cl.:
*H05K 7/20* *(2006.01)*          *C08J 5/04* *(2006.01)*
*H01L 23/373* *(2006.01)*     *H01L 23/42* *(2006.01)*

(21) Application number: **18845001.9**

(22) Date of filing: **27.07.2018**

(86) International application number:
**PCT/JP2018/028318**

(87) International publication number:
**WO 2019/031280 (14.02.2019 Gazette 2019/07)**

(54) **HEAT DISSIPATION SHEET HAVING HIGH THERMAL CONDUCTIVITY AND HIGH ELECTRIC INSULATION PROPERTY**

WÄRMEABLEITBLECH MIT HOHER WÄRMELEITFÄHIGKEIT UND HOHER ELEKTRISCHER ISOLIERUNG

FEUILLE DE DISSIPATION DE CHALEUR PRÉSENTANT UNE CONDUCTIVITÉ THERMIQUE ÉLEVÉE ET UNE PROPRIÉTÉ D'ISOLATION ÉLECTRIQUE ÉLEVÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.08.2017   JP 2017156016**

(43) Date of publication of application:
**17.06.2020 Bulletin 2020/25**

(73) Proprietor: **Denka Company Limited**
**Tokyo 103-8338 (JP)**

(72) Inventors:
• **WADA,Kosuke**
**Omuta-city**
**Fukuoka 836-8510 (JP)**
• **YAMAGATA,Toshitaka**
**Omuta-city**
**Fukuoka 836-8510 (JP)**
• **KANEKO,Masahide**
**Omuta-city**
**Fukuoka 836-8510 (JP)**
• **TANIGUCHI,Yoshitaka**
**Omuta-city**
**Fukuoka 836-8510 (JP)**

(74) Representative: **Gulde & Partner**
**Patent- und Rechtsanwaltskanzlei mbB**
**Wallstraße 58/59**
**10179 Berlin (DE)**

(56) References cited:
JP-A- H 091 738          JP-A- H08 336 878
JP-A- 2004 244 491     JP-A- 2009 274 929
JP-A- 2010 093 045     US-A- 6 096 414
US-A1- 2006 228 542

**Description**

Technical Field

The present invention relates to a heat dissipating sheet to be tightly attached to an interface between an electronic component, and a heat-dissipating part such as a heatsink or a circuit board for cooling the heat-releasing electronic component.

Background Art

In general, a heat dissipating sheet is obtained by applying a silicone composition containing a thermally conductive filler (hereinbelow, referred to as a silicone composition) onto both faces of a reinforcing layer such as a glass cloth, and due to excellent properties of the heat dissipating sheet such as high thermal conductivity, electrical insulation properties and handleability, is used in the field of electronic materials in such a way that the heat dissipating sheet is tightly attached to an interface between an electronic component and a heat-dissipating part such as a heatsink or a circuit board, for the purpose of cooling the heat-releasing electronic components. For example, each of the following Patent Literatures 1 to 6 disclose a heat dissipating sheet including a thermally conductive layer disposed on a reinforcing layer.

However, electronic components have been rapidly downsized with a higher degree of integration and a higher output in recent years, and this leads to higher operating temperatures and higher output voltages. As a result of this, conventional heat dissipating sheets have the following problem: malfunction and insulation failure occur due to unsatisfactory heat dissipation and insulation properties. Therefore, there is a need for a heat dissipating sheet having higher thermal conductivity and higher insulation properties.

Nevertheless, although a conventional technique for the purpose of providing a heat dissipating sheet with higher thermal conductivity is, for example, to use a large amount of a thermally conductive filler to accomplish such a purpose, such a conventional technique increases structural defects such as voids in the heat dissipating sheet to result in decrease in the insulation properties. Also, the thermal conductivity may be enhanced by using an expensive metallic foil as a reinforcing layer; however, in this case, problems are that the insulation properties decrease due to the use of the conductive material, and also that the cost increases.

Also, in a conventional technique for enhancing insulation properties, the insulation properties may be greatly increased by using a glass cloth or a polyimide film having high insulation properties as a reinforcing layer. A glass cloth is made by interweaving bundles of a plurality of glass fibers, and when a glass cloth having openings is used, heat transfer in a thermally conductive filler is not completely blocked, and as a result of this, decrease in the thermal conductivity of the heat dissipating sheet may be reduced. In this regard, when a glass cloth is used, a problem is that an air space is present between fibers within a glass cloth. When an air space is present in a fiber bundle within the glass cloth, on application of a voltage on the heat dissipating sheet, partial discharge occurs, and the insulation properties are not entirely ensured. Therefore, the thermal conductivity and the insulation properties may be further improved by impregnating an air space between fibers in a glass cloth with a thermally conductive filler and a silicone resin; however, the formulation of the above resin composition, the distribution of the particle sizes of the thermally conductive fillers, and the shape of particles have not been taken into consideration in relation to the fiber diameter of the conventional glass cloth. It is not preferable to use a polyimide film, because the thermal conductivity of polyimide itself is low, the heat transfer between the thermally conductive fillers is blocked by the polyimide film to result in decrease in the thermal conductivity of the heat dissipating sheet, and also the cost is high.

Also, efforts have been made to enhance heat dissipation by reducing the thickness of the heat dissipating sheet; however, such efforts inevitably impair the insulation properties, and therefore, the above-described problems have not been solved.

In view of the above-described problems, there is an increasing demand for excellent a heat dissipating sheet having excellent thermal conductivity and insulation properties.

Citation List

Patent Literature

Patent Literature 1: Japanese Patent Laid-Open No. 8-336878
Patent Literature 2 Japanese Patent Laid-Open No. 9-001738
Patent Literature 3: Japanese Patent Laid-Open No. 11-307697

Patent Literature 4: Japanese Patent Laid-Open No. 7-266356
Patent Literature 5: Japanese Patent Laid-Open No. 9-199880
Patent Literature 6: JP2009274929 A

Summary of Invention

Technical Problem

In view of the above-described problems in conventional technologies, it is an object of the present invention to provide a heat dissipating sheet having both of high thermal conductivity and high insulation properties.

Solution to Problem

As the results of diligent studies to solve the above problems, the present inventors have been found that, by means of employing a configuration in which a silicone composition layer containing aluminum oxide is laminated on both faces of a glass cloth as a reinforcing layer, and the silicone composition is contained in the glass cloth, and by means of appropriately adjusting the average sphericity and the average particle size aluminum oxide in the silicone composition layer, and also appropriately adjusting the fiber diameter and the opening ratio of the glass cloth, a space between fibers in the glass cloth is impregnated with the silicone composition to obtain a heat dissipating sheet having both of excellent thermal conductivity and excellent insulation properties.

In one embodiment according to the present invention that has been accomplished based on the above findings, a heat dissipating sheet having a configuration in which a silicone composition layer containing aluminum oxide is laminated on both faces of a glass cloth as a reinforcing layer, and the silicone composition is contained in the glass cloth, wherein an average sphericity of aluminum oxide is 0.85 or more, maximum peaks are present in a region of 15 to 50 $\mu$m, a region of 1 to 7 $\mu$m, and a region of 0.1 to 0.8 $\mu$m in a frequency particle-size distribution of the aluminum oxide, an average particle size of the aluminum oxide is in the range of 7 to 50 $\mu$m, a content of the aluminum oxide in the silicone composition is in the range of 62 to 78% by volume, and a content of a silicone resin in the silicone composition is in the range of 22 to 38% by volume, the glass cloth of the heat dissipating sheet is a woven article made of a glass fiber bundle obtained by bundling a plurality of glass filaments, and a ratio of impregnation of the glass fiber bundle with the silicone resin composition is 20% or more.

In another embodiment of a heat dissipating sheet according to the present invention, the heat dissipating sheet may be a roll-shaped heat dissipating sheet, and in another embodiment, the thermal conductivity of the heat dissipating sheet may be 2.0 W/(m·K) or more, and in another embodiment, the volume resistivity of the heat dissipating sheet may be $10^{13}$ $\Omega$·cm or more, and in another embodiment, it is possible to provide a heat-dissipating member including a heat dissipating sheet.

Advantageous Effects of Invention

A heat dissipating sheet according to the present invention may have both of high thermal conductivity and high insulation properties. In addition, such a heat dissipating sheet may be prepared in the form of roll that enables efficient and automatic blanking.

Description of Embodiments

Hereinbelow, the present invention will be described in more detailed way. Unless otherwise stated, numerical ranges shown in the present specification include both of the lower limit value and the upper limit value.

A heat dissipating sheet according to the present invention includes a glass cloth as a reinforcing layer, and a layer of a silicone composition having a predetermined nature laminated on both faces of the reinforcing layer, and the silicone composition is also contained in the glass cloth. Silicone is known to have a nature regarding a material suitable for use in the field of electronic materials, and is characterized by having electrical insulation properties stable over a broad temperature range and excellent thermal conductivity, and also having water resistance and the like. The present inventors have been found that excellent thermal conductivity and insulation properties for a heat dissipating sheet are provided by additionally optimizing the average sphericity, the particle size distribution and the average particle size of aluminum oxide in relation to a silicone composition obtained from such a silicone, and have accomplished the present invention.

[Reinforcing Layer]

The reinforcing layer allowed for use in a heat dissipating sheet according to the present invention includes a glass cloth to provide the heat dissipating sheet with mechanical strength, and in addition, suppress the stretching in a direction of a flat face of the heat dissipating sheet, and in addition, provide thermal conductivity and insulation properties. In a certain embodiment, as long as an effect of the present invention is not impaired, the reinforcing layer may further include other materials depending on applications of the heat dissipating sheet, and in the case of a heat dissipating sheet for use in the field of electronic materials, examples of such other materials may include resin films (polyester, polyamide, polyimide, polycarbonate, acrylic resins, and the like), mesh cloths made of fibers for fabrics (cotton, hemp, aramid fibers, cellulose fibers, nylon fibers, polyolefin fibers, and the like), nonwoven fabrics (aramid fibers, cellulose fibers, nylon fibers, polyolefin fibers, and the like), mesh cloths made of metallic fibers (stainless steel, copper, aluminum, and the like), or metallic foils (copper foils, nickel foils, aluminum foils, and the like).

As the above-described glass cloth, it is possible to use a glass cloth having openings that is commonly sold on the market. In the present specification, a glass cloth refers to a woven article made of a glass fiber bundle obtained by bundling a plurality of glass filaments. In view of the thermal conductivity, the thickness of the glass cloth may be, for example, in the range of 10 $\mu$m to 150 $\mu$m (0.01 to 0.15 mm), more preferably in the range of 20 to 90 $\mu$m, and further preferably in the range of 30 to 60 $\mu$m. When the thickness of the glass cloth is 10 $\mu$m or more, the handling of the heat dissipating sheet is facilitated due to improved strength of the heat dissipating sheet. When the thickness of the glass cloth is 150 $\mu$m or less, the thermal conductivity may be improved. The fiber diameter of the glass cloth is preferably in the range of 3 to 7 $\mu$m. When the fiber diameter of the glass cloth is 3 $\mu$m or more, the strength of the heat dissipating sheet is improved. When the fiber diameter of the glass cloth is 7 $\mu$m or less, the impregnation of the glass cloth fiber bundle with the silicone composition is improved. The tensile strength of the glass cloth may be, for example, in the range of 100 to 1000 N/25 mm. In a view of balancing the thermal conductivity and the strength, the length of one side of an opening in a glass cloth may be, for example, in the range of 0.1 mm or more and 1.0 mm or less.

The glass filament employed in a glass cloth for use as a reinforcing layer is preferably in the form of a string obtained by pulling a basis material made of glass melted at a high temperature out of a nozzle at high speed. The glass filament subjected to heat treatment or coupling agent treatment is more preferable because the content of impurities in such a glass filament is reduced.

[Silicone Composition Layer]

As a result of setting the average sphericity, the particle size distribution, the average particle size and the content of aluminum oxide to be in the predetermined respective ranges, the silicone composition layer allowed for use in a heat dissipating sheet according to an embodiment of the present invention may be bonded to the above-described reinforcing layer to cooperate with one another in such a way that remarkable thermal conductivity and insulation properties may be obtained.

The silicone composition may be a silicone resin (resin of silicone) or a silicone rubber, the type of silicone components in the silicone composition is not limited in particular; however, it is possible to use a silicone component of peroxide curing type, condensation curing type, addition reaction curing type, or ultraviolet ray curing type in a convenient manner. In particular, it is believed that the silicone rubber is preferable because an effect of the present invention tends to be achieved due to the elasticity and the hardness of the silicone rubber.

The average sphericity of the aluminum oxide of the silicone composition is 0.85 or more, and more preferably 0.90 or more. When the average sphericity is less than 0.85, it is difficult to increase a mixing ratio of the aluminum oxide in a resin and the like, and as a result of this, satisfactorily high thermal conductivity is not provided, and in addition, due to decrease in the flowability of the composition, there is no impregnation of the glass fiber bundle in the glass cloth, and it is therefore difficult to enhance the thermal conductivity and the insulation properties. The average sphericity in the present specification may be determined by using a flow particle-image analyzer.

The average particle size of aluminum oxide in the silicone composition is 7 to 50 $\mu$m. When this average particle size is less than 7 $\mu$m, a problem is that the thermal conductivity in not improved, and when this average particle size is greater than 50 $\mu$m, a problem is that the insulation properties are not improved, the wear of the mixer occurs to a large extent. In addition to the average particle size of aluminum oxide being in the range of 7 to 50 $\mu$m, it is preferable that, in frequency particle-size distribution, the particle size distribution of aluminum oxide has at least one maximum peak in each of a region of 15 to 50 $\mu$m and a region of 1 to 7 $\mu$m (hereinbelow, the maximum peak appearing in the region of 15 to 50 $\mu$m may be referred to as "peak 1", and the maximum peak appearing in the region of 1 to 7 $\mu$m may be referred to as "peak 2".), and in particular, further has at least one maximum peak in a region of 0.1 to 0.8 $\mu$m (hereinbelow, the maximum peak appearing in the region of 0.1 to 0.8 $\mu$m is also referred to as "peak 3".). This enables the loading of aluminum oxide at a higher content, and the thermal conductivity may be further enhanced due to increase in contact points. When aluminum oxide is loaded at a higher content and the amount loaded is at the same level, particles are closely packed in relation to one another to improve the slip, and as a result of this, the flowability may be maintained at a high level. In addition, a silicone composition having such a particle size distribution improves the ratio of impregnation of the glass fiber bundle in the glass cloth, and therefore, the thermal conductivity and the insulation properties may be dramatically improved.

The average particle size in the present specification refers to the average diameter of a particle and may be determined by an apparatus for measuring particle size distribution using laser diffraction.

The content of aluminum oxide in the silicone composition is 62 to 78% by volume, and particularly 65 to 73%, and the content of the silicone resin is 22 to 38% by volume, and particularly 27 to 35% by volume. When the content of aluminum oxide is greater than 78% by volume, or the content of the silicone resin is less than 22% by volume, the viscosity of the composition may increase to impair the formability, or voids may occur in the heat dissipating sheet to decrease the insulation properties. When the content of aluminum oxide is less than 62% by volume, or the content of the silicone resin is greater than 38% by volume, it is difficult to increase the thermal conductivity of the composition satisfactorily.

The ratio of impregnation of the glass fiber bundle in the glass cloth of the heat dissipating sheet with the silicone resin composition is 20% or more, and more preferably 40% or more. When the ratio of impregnation is less than 20%, the air spaces in the glass cloth fiber bundle increase in number to decrease the thermal conductivity and the insulation properties to a large extent.

The method for applying the silicone composition is not limited in particular, and it is possible to employ known application methods enabling homogeneous application, such as doctor blade method, a Comma Coater method, screen-printing and a roll coater method; however, in view of the accuracy of the thickness of the silicone composition, the doctor blade method and the Comma Coater method are preferable.

Although the thickness of the heat dissipating sheet is not limited in particular, the thickness of the heat dissipating sheet is typically about 0.05 to 1.2 mm, and in view of reducing thermal resistance, the thickness of the heat dissipating sheet is preferably 1.0 mm or less, and it is possible for the thickness of the heat dissipating sheet to be more preferably 0.4 mm or less, and further preferably 0.3 mm or less. The thickness of a single silicone composition layer is not limited in particular as long as the thickness is in a range enabling the acquirement of the function of the heat dissipating sheet; however, the thickness of a single silicone composition layer may be, for example, about 0.01 to 1.0 mm, and may be preferably about 0.05 to 0.5 mm.

For the sake of simple elucidation, the above description has illustrated an aspect in which the heat dissipating sheet exclusively includes two silicone composition layers and one glass cloth layer; however, as a matter of course, it is possible to provide any additional layer, or increase the number of the layers as long as the function of the heat dissipating sheet is not impaired. For example, an additional layer (an adhesive layer, a protection layer, a release paper, and the like) may be disposed on an open surface of the silicone composition layer. Alternatively, it is possible to employ an aspect in which a plurality of reinforcing layers is present, and an additional layer (adhesive layer, and the like) is disposed between the plurality of reinforcing layers.

In the above description, for the sake of convenience, the size of a face of the glass cloth (reinforcing layer) and the size of a face of the silicone composition layer have been described as if these sizes were the same; however, such a case is only for the purpose of illustration, and as long as the function of the heat dissipating sheet is not impaired, the size of a face of the reinforcing layer and the size of a face of the silicone composition layer may be different from one another, or the size of faces of the two silicone composition layers may be different from one another. The thickness of the two silicone composition layers may be the same or different. In a certain embodiment, an aspect may be present in which a plurality of silicone composition layers is disposed on the reinforcing layer (a plurality of silicone composition layers are separated by a face perpendicular to a surface of the sheet), or ways of separating the silicone composition layers on both faces of the reinforcing layer may be different from one another.

In a process for producing the heat dissipating sheet, a silicone composition layer and a glass cloth layer are bonded to one another. In one embodiment according to the present invention, it is preferable that the silicone composition is applied onto both faces of the glass cloth layer, followed by pressurization to achieve the bonding between the silicone composition layer and the glass cloth layer. When a roll-shaped heat dissipating sheet is produced, it is preferable for example that the bonding is performed under conditions of a linear pressure of 10 to 150 N/mm in the atmosphere by using a roll press machine. When the linear pressure is less than 10 N/mm, the following problem may occur: the bonding ability of the silicone composition and the glass cloth layer decreases. When the linear pressure is higher than 150 N/mm, the following problem may occur: the strength of the silicone composition and the glass cloth layer decrease. Subsequently, for the purpose of removing an alcohol, a carboxylic acid and a small molecule siloxane generated as by products in a cross-linking reaction of the silicone composition, it is preferable to perform secondary heating under conditions of 130 to 250°C for 5 to 30 hours to subject the silicone composition to thermal curing. The shape of a roll surface of the roll press is not limited in particular; however, this shape is preferably a satin-finish pattern, a matte-finish pattern, a checkerboard check pattern, a houndstooth pattern, and the like.

When a flat-sheet shaped heat dissipating sheet is produced, it is preferable for example that the bonding is achieved by applying a silicone composition onto a glass cloth layer, and subsequently, performing the bonding under conditions of a pressure of 700 to 2000 N/cm$^2$ at a temperature of 80°C to 170°C, and for a period of time of 10 to 60 minutes in the atmosphere by using a hot press machine. When the pressure is lower than 700 N/cm$^2$, the bonding temperature is lower than 80°C, or the bonding time is less than 10 minutes, the bonding ability between the silicone composition and the glass cloth decreases. When the pressure is higher than 2000 N/cm$^2$, the bonding temperature is higher than 170°C, or the bonding time is longer than 60 minutes, the strength of the silicone composition and the glass cloth layer decreases, and this is unpreferable in view of decrease in productivity. Note that this is not true when nitrogen, argon, hydrogen or vacuum is used as an atmosphere in the bonding. Subsequently, for the purpose of removing an alcohol, a carboxylic acid and a small molecule siloxane generated as by-products in a cross-linking reaction of the silicone resin, it is preferable to perform secondary heating under conditions of 130 to 250°C for 5 to 30 hours to subject the silicone resin to thermal curing.

Examples

(Example 1)

A polyorganosiloxane based polymer (manufactured by Dow Corning Toray Co., Ltd., trade name "CF3110") and a cross-linking agent (manufactured by Dow Corning Toray Co., Ltd., trade name "RC-4") were mixed in a weight ratio of 100: 1 to obtain a silicone resin component. The resulting silicone resin component, and an aluminum oxide powder as a thermally conductive filler were loaded into an agitator according to percent by volume shown in Tables 1 and 2, and mixed together by using the agitator for 15 hours to prepare a silicone composition containing aluminum oxide.

The average sphericity of the thermally conductive filler (aluminum oxide powder) was determined as below by using a flow particle-image analyzer (manufactured by SYSMEX CORPORATION, trade name "FPIA-3000"). The projected area (A) and the perimeter (PM) of the particle were determined from the particle image. When an area of a true circle corresponding to the perimeter (PM) is considered as (B), the sphericity of the particle of interest may be expressed as A/B. Therefore, when a true circle has a perimeter identical to the perimeter (PM) of the sample particle, $PM = 2\pi r$ and $B = \pi r^2$, and therefore, $B = \pi \times (PM/2\pi)^2$, and then, the sphericity of an individual particle may be calculated on the basis of $A/B = A \times 4\pi/(PM)^2$. The sphericity of each of arbitrarily selected 100 or more particles was measured, and the average value thereof was squared to obtain the average sphericity. The solution to be measured was prepared by adding 20 ml of distilled water and 10 ml of propylene glycol to 0.1 g of sample, followed by ultrasonic dispersion for 3 minutes.

The average particle size and the particle size distribution of the thermally conductive filler (aluminum oxide powder) were determined by using an apparatus for measuring particle size distribution using laser diffraction ("SALD-200" manufactured by Shimadzu Corporation). 50 cc of pure water and 5 g of a powder to be measured were added to a glass beaker, stirred with a spatula, and subsequently, subjected to dispersing treatment for 10 minutes by using an ultrasonic washing machine, and as a result of this, a sample solution to be evaluated was prepared. The sample solution to be evaluated was added dropwise to a sampler within the apparatus by using a pipette, the stabilization of the absorbance was awaited until the absorbance was measurable, and subsequently the absorbance was measured. The particle size distribution was calculated from data of the light intensity distribution regarding the diffraction/scattered light due to the particles detected by a sensor in an apparatus for measuring particle size distribution using laser diffraction. The average particle size was determined by multiplying the measured value of the particle size by the relative amount of the particles (%difference), and dividing the resulting value by the total relative amount of the particles (100%). With regard to Comparative Examples, in some cases, any of peaks 1 to 3 was out of the above range.

The above silicone composition was applied on one face of the glass cloth (manufactured by Unitika Ltd., trade name "H25") as a reinforcing layer shown in Table 1 or 2 by using Comma Coater to achieve a thickness of 0.175 mm, and was dried at 75°C for 5 minutes, and subsequently, the silicone composition is applied again onto the other face of the glass cloth by using Comma Coater to achieve a thickness of 0.175 mm, and as a result of this, a laminate was produced. Subsequently, press working was performed by using a roll press machine manufactured by Yuri Roll Co., Ltd. to produce a sheet having a thickness of 0.20 mm. Subsequently, the sheet was subjected to secondary heating at the normal pressure and 150°C for 4 hours to obtain a heat dissipating sheet.

(Examples 2 to 14 and Comparative Examples 1 to 10)

The heat dissipating sheets were produced in the same manner as in Example 1 except that the conditions shown in Tables 1 and 2 were used.

(Evaluation)

The prototyped heat dissipating sheets of Examples 1 to 14 and Comparative Examples 1 to 10 were evaluated according to the following evaluation items (1) to (5). The results are shown in Tables 1 and 2. With regard to Examples in which the heat dissipating sheet was not able to be normally produced in the form of sheet (due to the slack or cracks on the surface), "Impossible" is written in the entry of "Possible or impossible of sheet production".

(1) Volume Resistivity

The volume resistivity was evaluated according to a method described in JIS C2139:2008. As the measuring apparatus, an ultra megohmmeter (under trade name "SM-10E" manufactured by HIOKI E.E. CORPORATION) was employed.

(2) Thermal Conductivity

The thermal conductivity (H; in terms of W/(m·K)) was evaluated in a direction of the thickness of the heat dissipating sheet. According to $H = A \times B \times C$, the thermal conductivity was calculated from the thermal diffusivity (A; in terms of $m^2/sec$), the density (B; in terms of $kg/m^3$) and the specific heat capacity (C; in terms of $J/(kg \cdot K)$). The sample for use in the measurement was worked into a width of 10 mm $\times$ a length of 10 mm, and for the purpose of preventing the reflection of laser light for use in the measurement, carbon black was applied onto both faces of the heat dissipating sheet, and subsequently, the thermal diffusivity was determined by a laser flash method. As the measuring apparatus, a xenon flash analyzer (manufactured by NETZSCH, under trade name "LFA447NanoFlash") was employed. The density was determined according to the Archimedes method. The specific heat capacity was determined according to a method described in JIS K 7123:1987.

(3) Ratio of Impregnation of Glass Fiber Bundle with the Silicone Resin Composition

The ratio of impregnation of this glass fiber bundle with the silicone resin composition may be determined by the following expression.

The cross-section of the glass cloth in the heat dissipating sheet was subjected to imaging by using TVIP-4100 manufactured by Nippon Avionics Co., Ltd., and the ratio of impregnation was calculated according to the following expression.

$$\text{Ratio of impregnation} = S_2/(S_0 - S_1) \times 100 \ (\%)$$

$S_0$ = cross-sectional area of the glass fiber bundle
$S_1$ = total cross-sectional area of the glass filament in the glass fiber bundle
$S_2$ = cross-sectional area of the glass fiber bundle impregnated with the silicone composition

[Table 1]

| | | Unit | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|---|
| | Type | - | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide |
| Thermally conductive filler | Amount blended | vol% | 70 | 63 | 75 | 70 | 70 | 70 | 70 | 70 | 70 | 70 | 70 | 70 | 70 | 70 |
| | Average sphericity | - | 0.90 | 0.90 | 0.90 | 0.86 | 0.95 | 0.91 | 0.91 | 0.94 | 0.94 | 0.90 | 0.90 | 0.90 | 0.90 | 0.90 |
| | Average particle size | μm | 17 | 17 | 17 | 18 | 15 | 10 | 17 | 31 | 45 | 17 | 17 | 17 | 17 | 17 |
| | Peak 1 | μm | 22 | 22 | 22 | 24 | 21 | 15 | 15 | 35 | 40 | 22 | 22 | 22 | 22 | 22 |
| | Peak 2 | μm | 5 | 5 | 5 | 5 | 5 | 3 | 3 | 5 | 6 | 5 | 5 | 5 | 5 | 5 |
| | Peak 3 | μm | 0.5 | 0.5 | 0.5 | 0.5 | 0.5 | 0.5 | 0.2 | 0.5 | 0.5 | 0.5 | 0.5 | 0.5 | 0.5 | 0.5 |
| Silicone resin | Amount blended | vol% | 30 | 37 | 25 | 30 | 30 | 30 | 30 | 30 | 30 | 30 | 30 | 30 | 30 | 30 |
| Glass cloth | Fiber diameter | μm | 5 | 5 | 5 | 5 | 5 | 5 | 5 | 5 | 5 | 3.5 | 6 | 5 | 5 | 5 |
| | Thickness | mm | 0.04 | 0.04 | 0.04 | 0.04 | 0.04 | 0.04 | 0.04 | 0.04 | 0.04 | 0.04 | 0.04 | 0.02 | 0.08 | 0.13 |
| Ratio of impregnation of glass cloth fiber bundle | | % | 60 | 65 | 42 | 55 | 66 | 70 | 65 | 55 | 55 | 61 | 44 | 69 | 57 | 55 |
| Total thickness | | mm | 0.2 | 0.2 | 0.2 | 0.2 | 0.2 | 0.2 | 0.2 | 0.2 | 0.2 | 0.2 | 0.2 | 0.2 | 0.2 | 0.2 |
| Volume resistivity | | Ω·cm | $8.0 \times 10^{14}$ | $3.5 \times 10^{15}$ | $5.5 \times 10^{14}$ | $4.3 \times 10^{14}$ | $8.5 \times 10^{14}$ | $2.3 \times 10^{15}$ | $4.1 \times 10^{15}$ | $8.3 \times 10^{13}$ | $1.5 \times 10^{14}$ | $4.2 \times 10^{14}$ | $3.5 \times 10^{14}$ | $9.1 \times 10^{14}$ | $9.1 \times 10^{14}$ | $5.4 \times 10^{15}$ |
| Thermal conductivity | | W/(m·K) | 3.0 | 2.4 | 3.7 | 2.7 | 3.3 | 2.3 | 3.3 | 4.1 | 4.1 | 2.9 | 2.8 | 3.6 | 2.7 | 2.3 |
| Possible or impossible of sheet production | | - | Possible | Possible | Possible | Possible | Possible | Possible | Possible | Possible | Possible | Possible | Possible | Possible | Possible | Possible |

[Table 2]

| | | Unit | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 |
|---|---|---|---|---|---|---|---|---|---|---|---|---|
| Thermally conductive filler | Type | - | Aluminum oxide | Aluminum oxide | Aluminum oxide | Aluminum oxide | Aluminum oxide | Aluminum oxide | Aluminum oxide | Aluminum oxide | Aluminum oxide | Aluminum oxide |
| | Amount blended | vol% | 58 | 85 | 75 | 70 | 70 | 70 | 70 | 70 | 70 | 70 |
| | Average sphericity | - | 0.90 | 0.90 | 0.75 | 0.86 | 0.91 | 0.90 | 0.90 | 0.91 | 0.90 | 0.90 |
| | Average particle size | $\mu$m | 17 | 17 | 19 | 5 | 58 | 17 | 19 | 45 | 17 | 17 |
| | Peak 1 | $\mu$m | 22 | 22 | 21 | 10 | 65 | 22 | 22 | 40 | 22 | 22 |
| | Peak 2 | $\mu$m | 5 | 5 | 6 | 4 | 6 | 6 | 5 | 6 | 5 | 5 |
| | Peak 3 | $\mu$m | 0.5 | 0.5 | 0.5 | 0.5 | 0.5 | 2 | - | 0.5 | 0.5 | 0.5 |
| Silicone resin | Amount blended | vol% | 42 | 15 | 25 | 30 | 30 | 30 | 30 | 30 | 30 | 30 |
| Glass cloth | Fiber diameter | $\mu$m | 5 | 5 | 5 | 5 | 5 | 5 | 5 | 1 | 10 | 3 |
| | Thickness | mm | 0.04 | 0.04 | 0.04 | 0.04 | 0.04 | 0.04 | 0.04 | 0.04 | 0.04 | 0.005 |
| Ratio of impregnation of glass cloth fiber bundle | | % | 40 | - | 12 | 60 | - | 14 | 7 | - | 14 | - |
| Total thickness | | mm | 0.2 | - | 0.2 | 0.2 | - | 0.2 | 0.2 | - | 0.2 | - |
| Volume resistivity | | $\Omega$·cm | $8.0\times10^{14}$ | - | $81\times10^{12}$ | $49\times10^{14}$ | - | $8.0\times10^{12}$ | $7.0\times10^{12}$ | - | $6.4\times10^{12}$ | - |
| Thermal conductivity | | W/(m·K) | 1.5 | - | 2.4 | 1.3 | - | 2.9 | 3.0 | - | 1.9 | - |
| Possible or impossible of sheet production | | - | Possible | Impossible | Possible | Possible | Impossible | Possible | Possible | Impossible | Possible | Impossible |

EP 3 668 290 B1

9

From Examples in Table 1 and Comparative Examples in Table 2, it can be seen that the heat dissipating sheets according to Examples of the present invention have excellent thermal conductivity and high insulation properties.

Industrial Applicability

The heat dissipating sheet of the present invention has high thermal conductivity and excellent electrical insulation properties, and therefore, may be used in TIM (Thermal Interface Material) for the purpose of efficiently releasing heat from electronic components whose operating temperature becomes higher with rapidly growing performance, and the like.

**Claims**

1. A heat dissipating sheet having a configuration in which a layer of a silicone composition containing aluminum oxide is laminated on both faces of a glass cloth as a reinforcing layer, and the silicone composition is contained in the glass cloth, **characterized in that**

   an average sphericity of the aluminum oxide is 0.85 or more,
   maximum peaks are present in a region of 15 to 50 $\mu$m, a region of 1 to 7 $\mu$m, and a region of 0.1 to 0.8 $\mu$m in a frequency particle-size distribution of the aluminum oxide,
   an average particle size of the aluminum oxide is in the range of 7 to 50 $\mu$m,
   a content of the aluminum oxide in the silicone composition is in the range of 62 to 78% by volume, and a content of a silicone resin in the silicone composition is in the range of 22 to 38% by volume,
   the glass cloth is a woven article made of a glass fiber bundle obtained by bundling a plurality of glass filaments, and
   a ratio of impregnation of the glass fiber bundle with the silicone composition is 20% or more.

2. The heat dissipating sheet according to claim 1,
   wherein a thickness of the glass cloth is 0.01 to 0.15 mm, and a fiber diameter of the glass cloth is 3 to 7 $\mu$m.

3. The heat dissipating sheet according to claim 1 or 2, wherein the heat dissipating sheet is a roll-shaped heat dissipating sheet.

4. The heat dissipating sheet according to any one of claims 1 to 3, wherein a thermal conductivity of the heat dissipating sheet is 2.0 W/(m·K) or more.

5. The heat dissipating sheet according to any one of claims 1 to 4, wherein a volume resistivity of the heat dissipating sheet is $10^{13}$ $\Omega$·cm or more.

6. A heat-dissipating member, comprising a heat dissipating sheet according to any one of claims 1 to 5.

**Patentansprüche**

1. Wärmeableitmatte mit einer Konfiguration, bei der eine Schicht aus einer Siliconzusammensetzung, die Aluminiumoxid enthält, als Verstärkungsschicht auf beide Seiten eines Glastuches laminiert ist und die Siliconzusammensetzung in dem Glastuch enthalten ist,
   **dadurch gekennzeichnet, dass**

   eine durchschnittliche Sphärizität des Aluminiumoxids 0,85 oder mehr beträgt,
   in einer Häufigkeit-Partikelgrößen-Verteilung des Aluminiumoxids maximale Spitzen in einem Bereich von 15 bis 50 $\mu$m, einem Bereich von 1 bis 7 $\mu$m und einem Bereich von 0,1 bis 0,8 $\mu$m vorhanden sind,
   eine durchschnittliche Partikelgröße des Aluminiumoxids im Bereich von 7 bis 50 $\mu$m liegt,
   ein Gehalt des Aluminiumoxids in der Siliconzusammensetzung im Bereich von 62 bis 78 Vol.-% liegt und ein Gehalt eines Siliconharzes in der Siliconzusammensetzung im Bereich von 22 bis 38 Vol.-% liegt,
   das Glastuch ein Weberzeugnis ist, das aus einem Glasfaserbündel hergestellt ist, das durch Bündeln einer Mehrzahl von Glasfilamenten erhalten wird, und
   ein Maß der Tränkung des Glasfaserbündels mit der Siliconzusammensetzung 20 % oder mehr beträgt.

**2.** Wärmeableitmatte nach Anspruch 1, wobei eine Dicke des Glastuches 0,01 bis 0,15 mm beträgt und ein Faserdurchmesser des Glastuches 3 bis 7 $\mu$m beträgt.

**3.** Wärmeableitmatte nach Anspruch 1 oder 2, wobei die Wärmeableitmatte eine rollenförmige Wärmeableitmatte ist.

**4.** Wärmeableitmatte nach einem der Ansprüche 1 bis 3, wobei eine Wärmeleitfähigkeit der Wärmeableitmatte 2,0 W/(m·K) oder mehr beträgt.

**5.** Wärmeableitmatte nach einem der Ansprüche 1 bis 4, wobei ein spezifischer Volumenwiderstand der Wärmeab-leitmatte $10^{13}$ $\Omega$·cm oder mehr beträgt.

**6.** Wärmeableitelement, das eine Wärmeableitmatte nach einem der Ansprüche 1 bis 5 umfasst.

**Revendications**

**1.** Feuille de dissipation de chaleur présentant une configuration dans laquelle une couche d'une composition de silicone contenant un oxyde d'aluminium est plaquée sur les deux faces d'un tissu de verre servant de couche de renforcement, et la composition de silicone est contenue dans le tissu de verre,
**caractérisée en ce que**

une sphéricité moyenne de l'oxyde d'aluminium est égale ou supérieure à 0,85,
des pics maximaux sont présents dans une plage de 15 à 50 $\mu$m, une plage de 1 à 7 $\mu$m, et une plage de 0,1 à 0,8 $\mu$m dans une distribution de tailles de particules en fréquences de l'oxyde d'aluminium,
une taille de particule moyenne de l'oxyde d'aluminium est comprise dans la plage de 7 à 50 $\mu$m,
une teneur en oxyde d'aluminium dans la composition de silicone est comprise dans la plage de 62 à 78 % en volume, et une teneur en résine silicone dans la composition de silicone est comprise dans la plage de 22 à 38 % en volume,
le tissu de verre est un article tissé composé d'un faisceau de fibres de verre obtenu en groupant en faisceaux une pluralité de filaments de verre, et
un rapport d'imprégnation du faisceau de fibres de verre avec la composition de silicone est égal ou supérieur à 20 %.

**2.** Feuille de dissipation de chaleur selon la revendication 1, dans laquelle une épaisseur du tissu de verre est de 0,01 à 0,15 mm, et un diamètre de fibres du tissu de verre est de 3 à 7 $\mu$m.

**3.** Feuille de dissipation de chaleur selon la revendication 1 ou 2, dans laquelle la feuille de dissipation de chaleur est une feuille de dissipation de chaleur en forme de rouleau.

**4.** Feuille de dissipation de chaleur selon une quelconque des revendications 1 à 3, dans laquelle une conductivité thermique de la feuille de dissipation de chaleur est égale ou supérieure à 2,0 W/(m·K).

**5.** Feuille de dissipation de chaleur selon une quelconque des revendications 1 à 4, dans laquelle une résistivité transversale de la feuille de dissipation de chaleur est égale ou supérieure à $10^{13}$ $\Omega$·cm.

**6.** Élément de dissipation de chaleur, comprenant une feuille de dissipation de chaleur selon une quelconque des revendications 1 à 5.

**EP 3 668 290 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8336878 A
- JP 9001738 A
- JP 11307697 A
- JP 7266356 A
- JP 9199880 A
- JP 2009274929 A